# EUROPEAN PATENT SPECIFICATION

(11) **EP 2 862 956 B1**
(45) Date of publication and mention of the grant of the patent: **20.07.2022**
(21) Application number: 13189388.5
(22) Date of filing: 18.10.2013
(51) Int. Cl.: C23C 16/46, C23C 16/48, C23C 16/54

(54) **Roller device for vacuum deposition arrangement, vacuum deposition arrangement with roller and method for operating a roller**
Walzenvorrichtung zur Vakuumabscheidungsanordnung, Vakuumabscheidungsanordnung mit einer Walze und Verfahren zum Betrieb einer Walze
Dispositif à rouleaux pour dispositif de dépôt sous vide, dispositif de dépôt sous vide avec rouleau et procédé pour faire fonctionner un rouleau

(43) Date of publication of application: 22.04.2015
(73) Proprietor: Applied Materials, Inc., Santa Clara, CA 95054 (US)
(72) Inventor: Sauer, Andreas, 63762 Großostheim (DE); Henrich, Jürgen, 63694 Limeshain (DE); Deppisch, Thomas, 63743 Aschaffenburg (DE); Wagner, Dirk, 35423 Lich (DE)
(74) Representative: Zimmermann & Partner Patentanwälte mbB

(56) References cited:
- JP-A- 2001 098 382
- JP-A- 2002 076 394
- JP-A- 2002 212 744
- H TAMAGAKI ET AL: "Compact Vacuum Web Coating System for R&D", 55TH ANNUAL TECHNICAL CONFERENCE PROCEEDINGS, 12 February 2013 (2013-02-12), pages 210-214, XP055103961, ISBN: 978-1-87-806832-3

## Description

### TECHNICAL FIELD OF THE INVENTION

Embodiments of the present invention relate to a vacuum deposition apparatus with a roller device. Embodiments of the present invention particularly relate to a vacuum deposition apparatus with a roller arrangement for coating flexible substrates, specifically to guiding roller arrangements for guiding flexible substrates during a vacuum deposition process. Embodiments of the present inventions further relate to a method for operating a roller arrangement in a vacuum deposition arrangement.

### BACKGROUND OF THE INVENTION

Processing of flexible substrates, such as plastic films or foils, is in high demand in the packaging industry, semiconductor industries and other industries. Processing may consist of coating of a flexible substrate with a desired material, such as a metal, in particular aluminum, semiconductor and dielectric materials, of etching and of other processing steps conducted on a substrate for the desired applications. Systems performing this task generally include a processing drum, e.g., a cylindrical roller, coupled to a processing system for transporting the substrate, and on which at least a portion of the substrate is processed. Further roller devices may help to guide and direct the substrate to be coated in the deposition chamber. For example, JP 2002 076394 A describes a thin film semiconductor material manufacturing device with a vacuum tank which is used as a reaction chamber, a gas exhaust system combined with a pressure control, high-frequency electrodes arranged in opposition to each other on one side of a film substrate, ground electrodes arranged on the other side of the film substrate, a heater for heating the film substrate and a transfer means for transferring the film substrate from an unwind roll to a wind-up roll between the ground electrodes and the high-frequency electrodes. Further, JP 2002 212744 A describes a device for manufacturing thin film semiconductors including a vacuum tank divided into a reaction chamber including a part of a drum roll, a high-frequency electrode, and a ground shield; and a non-reaction chamber including the other part of the drum roll and a film substrate carrying means. Furthermore, JP 2001 098382 A describes a system and method for forming deposit films.

Generally, an evaporation process, for instance a thermal evaporation process, can be utilized for depositing thin layers of metals which can be metallized onto flexible substrates. Roll-to-Roll deposition systems are also experiencing a strong increase in demand in the display industry and the photovoltaic (PV) industry. For example, touch panel elements, flexible displays, and flexible PV modules result in an increasing demand for depositing suitable layers in Roll-to-Roll coaters, particularly with low manufacturing costs.

Flexible substrates to be coated, such as substrates made out of synthetics like PET, HC-PET, TaC etc. may include considerable amounts of moisture. Outgassing of the moisture during the coating process under high vacuum conditions has a negative influence on the layer properties, such as layer adhesion, optical uniformity, TCO resistivity and further aspired layer qualities. One approach to enhance the outgassing of the substrate before deposition is to use a heated guide roller. In known systems, guide rollers are used, which are heated by a heat transfer medium, such as oil or water/alcohol mixtures. A disadvantage of such a roller is that it needs a vacuum tight sealing of the rotary feedthrough for the transfer medium via tubes. This leads to high friction problems. Also, a special heating and cooling device for water/alcohol mixtures or oil is required for regulating the temperature.

In view of the above, it is an object of the present invention to provide a deposition arrangement including a roller device and a method for operating a roller device in a vacuum deposition arrangement that overcome at least some of the problems in the art.

### SUMMARY OF THE INVENTION

In light of the above, a roller arrangement, a vacuum deposition arrangement and a method for heating a substrate in a vacuum deposition arrangement according to the independent claims are provided. Further aspects, advantages, and features of the present invention are apparent from the dependent claims, the description, and the accompanying drawings.

According to one embodiment, a deposition arrangement for depositing a material on a flexible substrate is provided. The deposition arrangement includes a vacuum chamber, a roller device within the vacuum chamber; and an electrical heating device within the roller device, wherein the heating device comprises a first end and a second end, and wherein the electrical heating device is held at the first end and at the second end. According to embodiments described herein, the roller device is passively driven and is configured to be driven by a motion of the flexible substrate only, wherein the roller device is rotatable with respect to the electrical heating device.

According to a further embodiment, method for heating a substrate in a vacuum deposition arrangement is provided. The method includes guiding the substrate in a vacuum chamber using a roller device in the vacuum chamber; holding an electrical heating device in the roller device at two ends of the electrical heating device; and electrically heating the roller device by the heating device in the roller device, while the roller is rotating with respect to the electrical heating device. According to embodiments described herein, the roller device is passively driven and is driven by a motion of the flexible substrate only.

Embodiments are also directed at apparatuses for carrying out the disclosed methods and include apparatus parts for performing each described method step. These method steps may be performed by way of hardware components, a computer programmed by appropriate software, by any combination of the two or in any other manner. Furthermore, embodiments according to the invention are also directed at methods by which the described apparatus operates. It includes method steps for carrying out every function of the apparatus.

### BRIEF DESCRIPTION OF THE DRAWINGS

So that the manner in which the above recited features of the present invention can be understood in detail, a more particular description of the invention, briefly summarized above, may be had by reference to embodiments. The accompanying drawings relate to embodiments of the invention and are described in the following:
- Fig. 1: show a schematic view of a deposition arrangement according to embodiments described herein;
- Fig. 2: shows a schematic view of a roller device and a heating device according to embodiments described herein;
- Fig. 3a: shows a schematic partial view of a roller device and a heating device according to embodiments described herein;
- Fig. 3b: shows a schematic partial view of a roller device and a heating device according to embodiments described herein;
- Fig. 4: shows a schematic view of a roller device and a heating device according to embodiments described herein;
- Fig. 5: shows a schematic sectional view of the roller device and the heating device shown in Fig. 4;
- Fig. 6: shows a schematic cross-sectional view of the roller device and the heating device of Fig. 5;
- Fig. 7: shows a schematic detailed cross sectional view of a heating device according to embodiments described herein;
- Fig. 8: shows a schematic view of a roller device and a heating device according to embodiments described herein;
- Fig. 9: shows a schematic view of a roller device and a heating device according to embodiments described herein;
- Fig. 10: shows a schematic view of a deposition arrangement according to embodiments described herein;
- Fig. 11: shows a flow chart of a method for heating a substrate according to embodiments described herein.

### DETAILED DESCRIPTION OF EMBODIMENTS

Reference will now be made in detail to the various embodiments of the invention, one or more examples of which are illustrated in the figures. Within the following description of the drawings, the same reference numbers refer to same components. Generally, only the differences with respect to individual embodiments are described. Each example is provided by way of explanation of the invention and is not meant as a limitation of the invention. Further, features illustrated or described as part of one embodiment can be used on or in conjunction with other embodiments to yield yet a further embodiment. It is intended that the description includes such modifications and variations.

Furthermore, in the following description, a roller device may be understood as a device, which provides a surface, with which a substrate (or a part of a substrate) may be in contact during the presence of the substrate in a deposition arrangement (such as a deposition apparatus or deposition chamber). At least a part of the roller device may include a circular-like shape for contacting the substrate. In some embodiments, the roller device may have a substantially cylindrical shape. The substantially cylindrical shape may be formed about a straight longitudinal axis or may be formed about a bent longitudinal axis. According to some embodiments, the roller device as described herein may be adapted for being in contact with a flexible substrate. The roller device as referred to herein may be a guiding roller adapted to guide a substrate while the substrate is coated (or a portion of the substrate is coated) or while the substrate is present in a deposition arrangement; a spreader roller adapted for providing a defined tension for the substrate to be coated; a deflecting roller for deflecting the substrate according to a defined travelling path; a processing roller for supporting the substrate during deposition, such as a coating roller or a coating drum; an adjusting roller or the like. The roller device as described herein may comprise a metal. In one embodiment, the surface of the roller device which is to be in contact with the substrate may be adapted for the respective substrate to be coated.

An electrical heating device as described herein should be understood as a heating device for heating the roller device, in which it is arranged. According to some embodiments, the electrical heating device may be a heating device heating a surface electromagnetically. For instance, the heating device may be an irradiation heating device, such as an infrared heating device, an induction heating device or the like. According to some embodiments, the electrical heating device is a contactless heating device. The contactless heating device may be able to bring the roller device, or a surface of the roller device, to a defined temperature without making contact with it, especially without making contact with it for the purpose of heating. It should be understood that the heating device may nevertheless have defined contact areas with the roller, e.g. for being supported in the roller device. In some embodiments, the roller device may have a certain heated length which is to be heated by the heating device and the heating device has no contact with the roller device over the heated length. According to some embodiments, the heating device may provide two ends and is adapted for being supported, held or fixed at both ends. In one embodiment, the heating device may have a substantially cylindrical form, wherein the two ends of the heating device are the two ends of the longitudinal axis of the substantially cylindrical heating device or wherein the two ends of the heating device include the two front sides of the substantially cylindrical heating device.

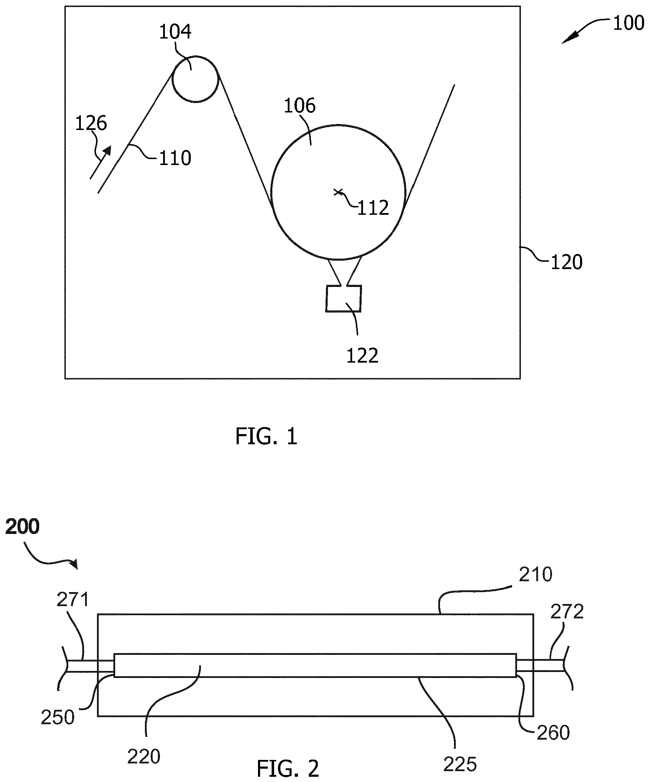

Fig. 1 is a schematic view of a deposition arrangement 100 according to embodiments described herein. The terms "coating" and "deposition" are used synonymously herein. The deposition arrangement 100 is adapted for processing a flexible substrate 110, such as, but not limited to, a web, a plastic film, or a foil.

A substrate as described herein may include materials like PET, HC-PET, PE, PI, PU, TaC, one or more metals, paper, combinations thereof, and already coated substrates like Hard Coated PET (e.g. HC-PET, HC-TAC) and the like.

The deposition arrangement 100, which is exemplarily shown in Fig. 1, includes a vacuum chamber 120. According to embodiments, processing of the flexible substrate is performed within vacuum chamber 120. In particular, a processing drum 106 may be disposed in the vacuum chamber 120 of exemplary deposition arrangement 100. Thereby, processing may be performed under vacuum conditions. For example, the vacuum chamber 120 may include a vacuum generating system (not shown) for providing the desired vacuum conditions within the vacuum chamber.

According to embodiments herein, the deposition arrangement 100 includes a first roller 104 adapted for transporting and/or stretching flexible substrate 110. In one embodiment, the first roller 104 is configured, e.g., disposed relative to processing drum 106, in a manner so that the flexible substrate 110 is stretched (i.e., stretched along the substrate width). Thereby, an appropriate transport of flexible substrate 110 onto processing drum 106 in direction 126 may be obtained and the formation of wrinkles in the flexible substrate 110 may be reduced upon being received by processing drum 106. According to typical embodiments, the first roller 104 may also be denoted as being a guiding roller.

According to embodiments herein, the processing drum 106 is rotatable with respect to a longitudinal axis 112 thereof. Thereby, the flexible substrate 110 may be transported and processed by being moved over a rotating processing drum 106. According to typical embodiments, the processing of flexible substrate 110 is effected, for example, but not limited thereto, by performing coating, plating, or a laminating process on a portion of flexible substrate 110, which is positioned over processing drum 106. A source of deposition material 122 is provided in the embodiment shown in Fig. 1.

The vacuum chamber 120 may be provided with an entrance adapted for facilitating the introduction of substrate 110 into the chamber while a vacuum condition is maintained therein. Alternatively, the roller system of the deposition arrangement 100, including unwinding and winding rollers (not shown in Fig. 1), may be contained in vacuum chamber 120.

However, as described above, the outgassing of a substrate during the deposition process may lead to problems regarding the quality of the end product. For this problem, several solutions are provided in known systems. For instance, there are solutions with additional heating chambers with heating zones. Besides the high cost of such an additional heating chamber, the indirect heating concept has only a limited effect. The desired substrate temperature for enhanced outgassing cannot easily be controlled in a desired manner in known systems. Further, in case of a machine stop, the temperature sensitive substrate could be destroyed by the hot heaters in the heating chamber.

Thus, the known approaches to solve the problem are expensive. Further, using drums with a temperature regulating liquid inside as mentioned above does not only require an extra device for the regulation of the liquid temperature but the drums also need to be actively driven, which increases the complexity of the deposition apparatus as well as the costs for the deposition arrangement.

According to some embodiments, a deposition arrangement is provided, which includes a roller device in a vacuum chamber. The roller device is equipped with an electrical heating device, which is held at both ends of the heating device. The roller device may be in contact with the substrate during handling of the substrate in the vacuum chamber or in a vacuum deposition apparatus. The electrical heating device may be placed within the roller device. According to some embodiments, the heating device as described herein may be adapted to heat the roller device, in particular to heat the roller device electromagnetically.

The heating device being located in the roller device is held at a first end and at a second end of the electrical heating device, e.g. at both ends if the heating device provides a substantially longitudinal shape, such as a cylinder-like shape or a plate like shape having a substantially rectangular cross section. According to some embodiments, the first end and the second end of the electrical heating device are located along the longitudinal direction of the electrical heating device. For instance, in case the electrical heating device has a substantially cylindrical shape, or a partly substantially cylindrical shape, the first end of the electrical heating device may be at the first front side of the heating device and the second end may be at the second front side of the heating device. According to some embodiments, an end of the heating device may also include, or extend over, about 10% of the length of the heating device. In some embodiments, the ends of the heating device are held by bearings or the like.

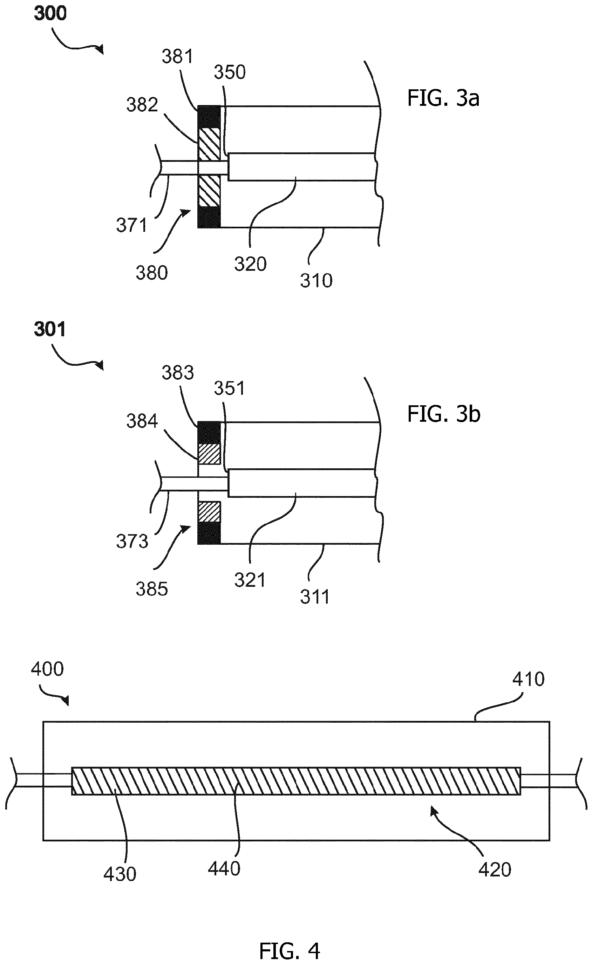

According to some embodiments, the ends of the heating device may be held by being supported. In some embodiments, holding the heating device may mean that the weight of the heating device is carried. In some examples of a deposition arrangement, the heating device may be fixed, fixed in the vacuum chamber, or fixed in the deposition arrangement. In one embodiment, the heating device may be coupled to the roller device, for instance, by being fixed to the roller device. In further embodiments, the heating device is supported and held outside or independently from the roller device. According to some embodiments, which may be combined with other embodiments described herein, the roller device and the heating device are rotatably connected with each other, as will be shown in detail below with respect to Fig. 3.

According to some embodiments, which may be combined with other embodiments described herein, also the roller device may be held or supported at two ends, such as the two ends in longitudinal direction of the roller device. For instance, the roller device may rotatably be supported at two ends, in particular, rotatably supported in the vacuum chamber at two ends. In case the roller device has a substantially cylindrical shape, the roller device may be held at both ends of the substantially cylindrical shape.

Fig. 2 shows an embodiment of a roller device 200, which may be used in a deposition arrangement according to embodiments described herein. For instance, the roller device 200 as shown in Fig. 2 may be used in the deposition arrangement 100 as exemplarily shown in Fig. 1. The roller device 200 may include a surface 210, which is adapted to be in contact with the substrate to be deposited. The surface 210 of the roller device 200 may be adapted to guide the substrate as a process roller, as a guiding roller, as a deflecting roller, or the like.

Although the figures only show straight roller devices, the roller devices shown in the figures may also be a spreader rollers, such as spreader rollers having a curved surface along the length direction of the roller. The curved surface of a spreader roller may have a tensioning effect in the width direction of the substrate.

Within the roller device 200, an electrical heating device 220 is provided. The electrical heating device 200 may be adapted to be operated in a vacuum, such as a vacuum deposition chamber. For instance, the electrical heating device may be adapted to the pressure fluctuation occurring while the deposition chamber is pumped down to vacuum conditions. This may be achieved by choosing a suitable design and construction of the heating device, suitable materials for the heating device, or suitable isolating materials for the heating device as will be explained in detail below.

According to some embodiments described herein, the heating device is adapted to provide the outer surface of the heating device substantially at the same electrical potential as the roller device during vacuum deposition. In Fig. 2, the outer surface of the heating device is denoted with reference sign 225. According to some embodiments, the outer surface of the heating device is the surface of the heating device facing the roller device. In one embodiment, the outer surface 225 of the heating device 220 and the roller device, specifically the surface 210 of the roller device 200, may both be at ground potential. In one embodiment, which may be combined with other embodiments described herein, the heating device and the roller device are adapted to hold the surface of the heating device facing the roller device substantially on the same potential as the roller device over the heating length during vacuum deposition.

The term "substantially" as used herein may mean that there may be a certain deviation from the characteristic denoted with "substantially." For instance, the term "substantially at the same potential" refers to a situation, where the potential of the two elements having substantially the same potential may have certain deviations from the exact same potential, such as a deviation of about 1% to 15% of the electrical potential of one of the elements. In one embodiment, having or being on "substantially the same potential" may be understood in that the difference of the potential between two elements having substantially the same potential is small enough so that there is no voltage discharge risk between the two elements especially under vacuum conditions.

Further, a shape being "substantially" cylindrical may refer to a shape of an element having a certain deviation from the exact cylindrical shape. For instance, the geometry of the substantially symmetrical shape may deviate up to about 15% of the total extensions in one direction from the cylindrical shape. Also, a substantially cylindrical shape as described herein may include a bent cylinder, having e.g. a cylinder having a bent longitudinal axis. In some embodiments, an element may be denoted as being substantially cylindrical if an outer mantle encompassing all components of that element is cylindrical. Further, the term "cylindrical" shall not be under stood as being limited to a cylinder having a circle-like base shape.

In the deposition arrangement according to embodiments described herein, the same vacuum may be present in the vacuum chamber and within the roller device. According to some embodiments, the "same vacuum" may mean that the deviation of the vacuum in the vacuum chamber outside the roller device and within the roller device is within a variation of the vacuum condition normal in a vacuum chamber, e.g. a vacuum chamber having a defined size. For instance, the "same vacuum" being present within the roller device and outside the roller device in the vacuum chamber may mean that the roller device with the heating device in it is not isolated with respect to the vacuum chamber. Rather, the roller device may be open with respect to the vacuum chamber of the deposition arrangement. Accordingly, the heating device operates under vacuum conditions in some embodiments. In the deposition arrangement, one vacuum generating arrangement may be used for the vacuum in the vacuum chamber and the inside of the roller device, in particular the same vacuum generating arrangement may be used for the vacuum in the vacuum chamber and the inside of the roller device. For instance, the vacuum in the vacuum chamber may be generated by the same vacuum pumps as the vacuum inside the roller device. According to some embodiments, exactly one vacuum generating arrangement or vacuum generating system may be used for generating the vacuum in the vacuum chamber and within the roller device. The vacuum generating arrangement may provide substantially the same vacuum condition in the vacuum chamber and within the roller device.

In Fig. 2, the first end 250 and the second end 260 of the heating device 220 can be seen, especially the first end 250 and the second end 260 can be seen as being located at the front sides of the substantially cylindrical shape of the heating device. Generally, the heating device in embodiments described herein, is held at the first end 250 and at the second end 260. According to some embodiments, the first end 250 of the heating device 220 is held by a first holding device 271, and the second end 260 of the heating device 220 is held by a second holding device 272.

In some embodiments, the heating device, especially both ends of the heating device, may be held by one holding device. For instance, the heating device may be held by one holding device extending along the length of the heating device in the roller device. In one example, the holding device, which provides the holding function for the first and the second end of the heating device, may provide a support of the heating device in the vacuum chamber or in the roller device.

According to some embodiments, the holding device or the holding devices may be supported in the vacuum chamber. For instance, the deposition arrangement may be adapted for fixing the holding devices holding the ends of the heating device within the roller device. In one embodiment, the deposition arrangement includes at each side of the heating device (with respect to the longitudinal axis) a support for fixing the holding devices. According to further embodiments, the holding devices are fixed outside the vacuum chamber of the deposition arrangement, or even outside the deposition arrangement. In some embodiments, the roller device may be supported by the holding devices, too, or the holding devices may be supported in the roller device, as explained in more detail with respect to Fig. 3. In some embodiments, which may be combined with other embodiments described herein, the holding device, or the holding devices, may include one bearing for each end of the heating device to be held.

The holding devices may be adapted for gripping the heating device and may be equipped accordingly, e.g. by gripping fingers, which are able to hold the heating device. According to some embodiments, the holding device and the heating device may be adapted so that they may be connected to each other by connecting means such as bolts, screws, pins, brads or the like. The heating device and the holding device may include respective recesses for housing the connecting means. In some embodiments, connecting means may be distributed over the circumference of the heating device. For instance, three connecting means may be distributed over the circumference of the heating device for connecting the heating device to the holding device.

According to some embodiments, the holding device or the holding devices may include one or more receptions for holding and guiding power supply lines for the power supply of the heating device. In one example, the holding device allows for connecting the power lines to the heating device, when the holding device is connected to the heating device.

In one embodiment, two holding devices are provided for being connected at each side of the heating device. Each of the holding devices may be adapted for carrying at least half the weight of the heating device.

Holding the electrical heating device and/or the roller device at both ends thereof may increase the stability of the deposition arrangement. Further, the higher stability compared to holding and/or fixing the heating device at only one end may allow broader substrates to be coated. This is due to the fact that an increased stability of the heating device allows for an increased length of the heating device and the roller device. An increased roller device length may in turn allow broader substrates to be guided and coated. This leads to higher process efficiency.

According to some embodiments described herein, the accuracy of the roller device arrangement in the vacuum chamber may be increased. For instance, by supporting the heating device and the roller device at both ends (and, in some embodiments, independently from one another), the roller device and the heating device may be held stable during processing, especially irrespective of the substrate weight or the duration of the process. In some embodiments, the accuracy of the position of a roller device being held at both ends may typically be in a range of about 1/100 mm to about 1/5 mm per meter length of the roller device, more typically between about 1/100 mm and about 1/10 mm per meter length of the roller device, and even more typically between about 1/100 mm and about 1/50 mm per meter length of the roller device. For instance, the position of the ends of the roller device deviates from the desired position by less than 1/10 mm per meter length. According to some embodiments, a high accuracy of the roller device position may be desirable for ensuring a reliable operation of the deposition arrangement. For instance, the accuracy of the position to the diverse roller devices in the deposition arrangement to each other (e.g. the parallelism between the roller devices) may be increased by increasing the accuracy of each single roller device position. Further, a high accuracy may be desired for a reliable (un-)winding of the substrate before and after the deposition process. A reliable deposition process reduces down times and spares costs for repair and maintenance.

Further, as explained above, holding the heating device at both ends allows for an "open" design of the roller device. An "open" design of the roller device may include a design, which is not vacuum-tight. For instance, the same vacuum is present in the vacuum chamber of the deposition arrangement and within the roller device. No complicated sealing structure has to be provided. Also, supplying power to the heating device is facilitated by the open design of the roller device and/or the holding of both ends of the heating device. For instance, power may be supplied from both ends to the heating device, depending on the design of the heating device and the constructional conditions of the deposition arrangement.

Fig. 3a shows a partial view of a roller device 300, which may be used in a deposition arrangement according to embodiments described herein. The roller device 300 includes a surface 310 to be in contact with the substrate to be coated. A heating device 320 can partially be seen in Fig. 3a. The heating device may be held at both ends, of which only one, namely end 350, is shown in Fig. 3a for the sake of simplicity. The first end 350 of the heating device 320 is held by a holding device 371. However, it should be understood that the second end of the heating device may also be equipped in the way described with respect to the first end.

Fig. 3a shows the holding device 371 holding the first end of the heating device. In the embodiment shown in Fig. 3a, the roller device 300 is rotatably connected to the holding device. For instance, the roller device 300 may rotatably be connected to the holding device by a bearing arrangement 380. The bearing arrangement 380 may allow the roller device to rotate on the holding device 371. In some embodiments, the bearing arrangement 380 includes a bearing 381 and a supporting element 382. The supporting element 382 may be provided for supporting the roller device 300, for instance on the holding device or in the vacuum chamber.

When connecting the roller device rotatably on the holding device holding the heating device inside the roller device, the roller device may be rotated about the heating device. Therefore, the surface of the roller device is uniformly heated by passing the heating device whilst rotating.

Fig. 3b shows an embodiment of a roller device 301 including a heating device 321. The roller device 301 is shown having a surface 311 to be in contact with the substrate during processing. Fig. 3b shows a detail of the roller device 300 and the heating device 321 including a first end 351, but, as in Fig. 3a, it should be understood that the second end may be designed in a similar way as the first end 351 of the heating device 321 shown in Fig. 3b.

As can be seen in the example of Fig. 3b, the heating device 321 is held by holding device 373. The roller device 301 may rotatably be provided by a bearing arrangement 385. In the embodiment shown in Fig. 3b, the bearing arrangement 385 includes a bearing 383, which allows the roller device 301 to rotate. The supporting element 384 supports the bearing 383 and may be supported by the deposition chamber, which the roller device 301 is arranged in. In some embodiments, the supporting element 384 may be a part of the deposition chamber. In the embodiment shown in Fig. 3b, there is no connection between the roller device 301 and the heating device 321. According to some embodiments, the roller device rotates independently from the heating device, in particular, without being connected to the heating device or vice versa.

According to some embodiments, which may be combined with other embodiments described herein, the heating device and the roller device may separately be supported. For instance, the heating device and the roller device may have separate support systems for holding the heating device and the roller device. In one example, the heating device may be supported in the vacuum chamber by one holding system and the roller device may be supported in the vacuum chamber by a holding system different from the holding system of the heating device, in particular, the heating device and the roller device may substantially have no connection to each other, or no structural connection to each other, or have no contact with each other.

Fig. 4 shows a roller device 400 according to embodiments, which may be combined with other embodiments described herein. The roller device 400 includes a surface 410 to be in contact with the substrate to be coated during the deposition process. Further, a heating device 420 is shown in Fig. 4. According to some embodiments, the heating device 420 includes a support 430 and a heating element 440, especially a heating tube. In the embodiment shown in Fig. 4, the heating element 440 is shown wound around the support 440.

It should be understood that the heating device may include a support and a heating element, which may be arranged on the support in any suitable way. Although embodiments described herein show a heating element wound around the support, a heating element as described herein may also be supported by the support in any way, such as running along the support, running along the support in several lines, being supported as a plurality of single heating elements and the like.

In some embodiments, the two ends of the heating device being held or fixed may be provided by the ends of the heating device support 430 carrying the heating element 440 of the heating device. For instance, the heating device 420 including a support 430 as shown in Fig. 4 may be held by the ends of the support 430.

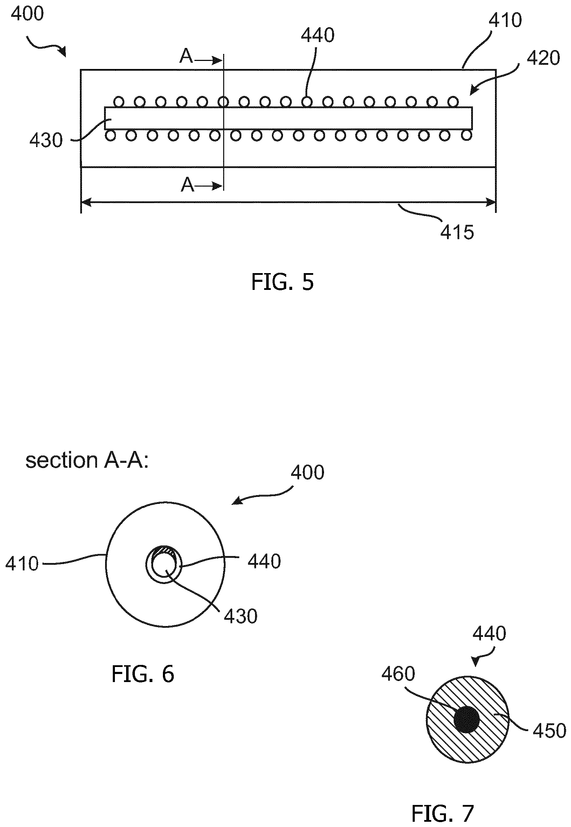

Fig. 5 is a sectional view along the longitudinal axis of the roller device 400 as described above with respect to Fig. 4. According to some embodiments, the heating element 440 (or heating tube) has a cross section as exemplarily shown in the sectional view of Fig. 5. It should be understood that the heating element or heating tube of a heating device according to some embodiments may have any suitable cross sectional shape.

According to some embodiments, the length of the roller device may approximately correspond to the width of the substrate to be coated. In some embodiments, the heated length of the roller device or the length of the heating device corresponds approximately to the width of the substrate to be coated. The heated length of the roller device may be measured along the longitudinal axis of the substantially cylindrical roller device, whereas a (continuous) web to be coated and being in contact with the roller device may have a width, which is substantially perpendicular to the moving direction.

In Fig. 5, the length 415 of the roller device 400 is shown. According to some embodiments, the length of the roller device (and/or the length of the heating device) may typically be between about 1.2 m and about 5 m, more typically between about 1.5 m and about 4.5 m, and even more typically between about 1.8 m and about 4.0 m. The length of the roller device may depend on the substrate to be coated (such as the width of the substrate), or the deposition arrangement in general (which may be adapted for several substrate widths) or further process parameters.

According to some embodiments, the number of windings of the heating element about the heating device support may typically be between 20 and 250, more typically between 40 and 200, and even more typically between 60 and 160. According to some embodiments, which may be combined with other embodiments described herein, the number of windings of the heating element around a support of the heating device may typically be between 20 and about 100 per meter length of the heating device, more typically between 40 and 80 per meter length of the heating device, and even more typically between 40 and 60 per meter length of the heating device. According to some embodiments, the windings may be set with an even higher density to each other in order to increase the surface of the heating device, in particular, when radiation heaters are used as heating elements.

The distance of the heating device windings may vary from the end to the center of the heating device according to the respective requirements (e.g. smaller distance where higher power is needed). Temperature uniformity may be achieved through a good thermal conductance (influenced by the parameters material and material thickness) of the roller material.

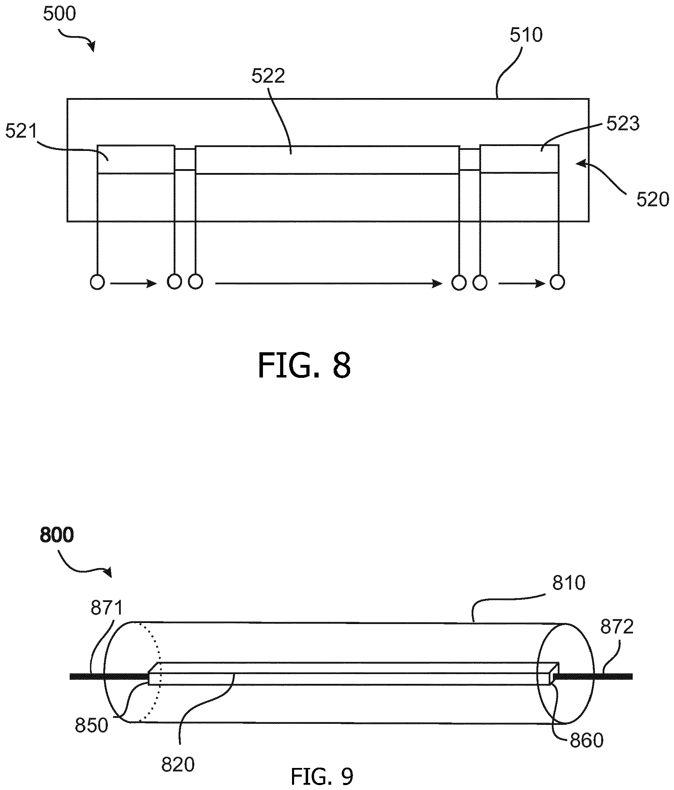

In some embodiments, the heating device may be segmented and the number of windings may be split up to the segments of the heating device as explained in detail below with respect to Fig. 8.

Fig. 6 shows a sectional view of the roller device 400 along line A-A as shown in Fig. 5. The outer surface 410 of the roller device 400 is shown in Fig. 6 as well as the supporting element 430 and the heating element 440 being in this example a heating tube. The heating tube can be seen in a partial sectional view and further windings of the heating tube can be seen in the background.

Fig. 7 shows an embodiment of a cross-section of a heating element 440 of a heating device. According to some embodiments, the heating device includes a heating element 440, a heating wire 460 for carrying current and being arranged within the heating element 440, and an isolating element 470 located in the heating element 440. In one embodiment, which may be combined with other embodiments described herein, the heating element as a part of the heating device may provide atmospheric pressure at the inside of the heating element. For instance, while the inside of the roller device is under vacuum, the inside of the heating element may stand under atmospheric pressure. Operating under atmospheric pressure may allow the heating wire to provide a more reliable and efficient operation.

According to some embodiments, the heating wire 460 may be encompassed by an isolating element 450 in the heating element as exemplarily shown in Fig. 7. The isolating element 450 may be granulate or any material which allows for isolating the heating wire 460 electrically with respect to the outer cover of the heating element 440. In some embodiments described herein, the heating element 440 provides the same electrical potential as the roller device. According to some embodiments, the heating element 440 is electrically neutral on the outside with respect to the roller device 400. The outside of the heating element should be understood as the side facing the roller device. The electrical neutral effect of the heating tube with respect to the roller device may be achieved by the isolating element surrounding the heating wire.

In some embodiments, holding the roller device and the heating device (or at least parts thereof) at substantially the same electrical potential may mean that the electrical potential of the outside side of the heating device (facing the roller device) may have a deviation of about 15% from the potential of the roller device, such as the inside side of the roller device facing the heating device. According to some embodiments, the potential of the heating device as well as of the roller device may be ground potential.

According to some embodiments, the power supply of the heating device may be adapted to the vacuum conditions in and around the roller device, in which the heating device is located. For instance, the heating device may be connected via a vacuum feed through to any kind of electrical power (e.g. 400 V AC). In some embodiments, the power supply for the heating device may be designed in a way that avoids voltage discharges in the vacuum chamber of the deposition arrangement. Such voltage discharges may cause damage to the equipment and/or may disturb the sensitive deposition process. For instance, the power supply to the heating device may be performed under atmospheric pressure, as for instance described with respect to the heating wire of the heating device. In one embodiment, a vacuum tight isolating tube may surround the power supply to the heating device. Further isolating layers may also be provided for electrically isolating the power supply to the heating device.

Fig. 8 shows a roller device 500 with a roller surface 510 and a heating device 520 in the roller device 500. In the embodiment shown in Fig. 8, the heating device 520 is divided into three heating device segments 521, 522, and 523. In the example shown in Fig. 8, the end parts of the heating device 520 have separate segments. According to some embodiments, which may be combined with other embodiments described herein, the heating device segments may be supplied by separate power supplies. The heating device segments may contain several windings, such as about ten windings for the outer segment 521 and 523 at a heating device length of about 1.5 m. In some embodiments, the heating device segments may have different heating devices, such as differing diameter of the heating tubes, different shape of the heating tubes, different densities of windings or even different kinds of heating devices and the like. According to some embodiments, the design of the heating device segments depends on the desired application, and may be adapted to the respective application.

As described above, the heating device may be held at both ends. In case of a segmented heating device, this has the advantage that the power supply of the single segments may be fed to the single segments from both sides of the heating device. For instance, the segment 521 in Fig. 8 may be supplied from the left side of the drawing, while the segment 523 may be supplied from the right side of the drawing. This would not, or only with difficulties, be possible in an arrangement, in which the heating device is only held at one side, or in a closed roller arrangement.

According to embodiments described herein, the segments of the heating device may be controlled individually, i.e. independently from one another. This may increase the flexibility in the process setup. In one example, the border region of the substrate may be exposed to a higher temperature loss compared to center regions of the substrate, e.g. due to the proximity of cold chamber walls. Thus, a segmented heating device may allow for adapting the heating power to the respective process conditions in different areas of the substrate.

As explained above, with the heating device being held at both ends thereof, the length of the heating device as well as the roller device may be increased. Although this arrangement allows for guiding and coating broader substrates, other applications may include guiding and coating substrates having a width less than the roller device length. If such a substrate is to be heated, in some embodiments, only the parts of the roller device may be heated which are to be in contact with the substrate. Thus, only segments may be operated which contribute to the heating of the desired area on the roller device, while other segments of the heating device may be switched off. This may increase the process efficiency and makes the deposition arrangement according to embodiments suitable for a plurality of different deposition applications.

An advantage of the herein described design, embodiments of which are exemplarily shown in Figs. 2 to 9, is that (plastic) films or webs may be heated very effectively in vacuum. In combination with radiation heaters (200°C - 300°C) being arranged downstream of the roller device according to embodiments described herein, an elevated film temperature can be achieved over a long distance without the risk of film damage during a stop. For instance, the heating device within the roller device may be used to heat the substrate to be coated up to a desired temperature, while downstream radiation heaters outside the roller device may provide the required energy for holding the temperature of the substrate over a defined length, or avoiding at least an undesired cooling of the substrate.

Another advantage of the herein described embodiments is that the heat transfer is very effective through direct contact between heated element (guide roller) and substrate (film). The heating method is further inexpensive (inter alia by using electrical power instead of heated fluids) and can be controlled automatically.

Further, also a non-driven roller may be heated. Due to the light construction of the roller device made possible by using the electrical heating element according to embodiments described herein, which is held at two ends, the roller device according to embodiments described herein is driven by the motion of the substrate to be coated only, i.e. the roller device is passively driven without the need of an active drive (such as a motor). According to some embodiments, the surface of the roller device may be adapted for being driven by the motion of the passing substrate. As shown above with respect to Fig. 3a and 3b, the heating device may be held by holding devices, which may be supported in the vacuum chamber. For instance, bearings may be provided for allowing the roller device to rotate due to the motion of the substrate. In some embodiments, the rotation of the roller device depends on the substrate mass or thickness. In one example, by driving the roller device by the substrate only, friction in the deposition arrangement may be reduced. In the embodiment shown in Fig. 3a, the roller device may be rotatably mounted on the holding devices so as to allow the roller device to rotate about the electrical heating device. Also, adapting the roller device for being driven by the substrate ensures a proper contact of the substrate to the roller device, and thus, a reliable heat transfer from the rolling device to the substrate.

According to other examples useful for understanding the invention, the roller device may be driven by a drive, such as a motor. By being driven by a drive, the roller device may rotate independently from the motion of the substrate to be coated and may, thus, also be driven and uniformly heated during a process break or the like. Further, the driven roller device may also transport the substrate to be coated.

Fig. 9 shows a further embodiment of a roller device 800 with a heating device 820 in it. The roller device 800 may have a surface 810 for being in contact with the substrate to be coated during deposition. As mentioned above, the surface 810 may be adapted so that the motion of the substrate causes a rotation of the roller device 800. The heating device 820 is held at both ends 850 and 860 of the substantially rectangular shape. For instance, the ends 850, 860 of the heating device 820 may be held by holding devices 871, 872. According to some embodiments, which may be combined with other embodiments described herein, the heating device 820 may comprise a carbon fiber carbon composite element (CFC). In some embodiments, the heating device comprises a heating element being electrically heated so that no further isolation with respect to the roller device may be desired. For instance, the heating element may be heated with a low voltage and a high current so that the risk of a voltage discharge is decreased.

According to some embodiments, which may be combined with other embodiments described herein, the heating device may comprise (although not shown in the drawings) heating elements like the above mentioned infrared heating elements including a quartz glass for a good transmission and a high temperature resistance, reflectors for high efficiency, heating elements with increased surface, heating devices having a length up to 5m, heating devices including bright emitters, heating devices adapted for providing temperatures up to 1000°C or above, and the like.

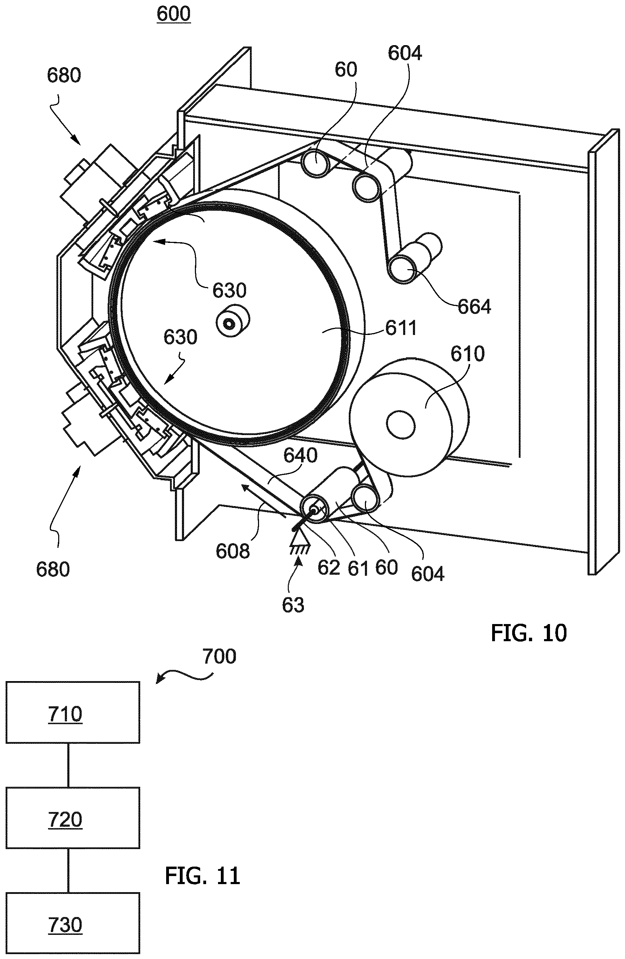

In one aspect, the use of a deposition arrangement according to embodiments is described, especially the use of a deposition arrangement according to embodiments described herein is described with respect to Fig. 10. FIG. 10 shows an example of a deposition apparatus 600, such as a coating apparatus. Not limited to this embodiment, the deposition apparatus may generally be configured to house a substrate (or web) storage spool, as it is illustrated in the embodiment of FIG. 10 and denoted by reference number 610. The web 640 is unwound from the storage spool 610 as indicated by the substrate movement direction shown by arrow 608.

The web 640 is guided via rollers 604 and, on each side of the coating unit 611, via one web guide unit 60. The coating unit may generally and not limited to the embodiment of FIG. 10 be a coating drum. According to embodiments, two or more rollers 604, and/or one, two, or more web guide units 60 being, for instance, roller devices according to embodiments described herein may be provided in the deposition apparatus 600, for instance, at each side of the coating unit 611.

According to some embodiments, the web guide unit 60 may be a roller device as described above. In the embodiment shown in Fig. 10, a heating device 61 is located within the roller device 60. As can be seen in Fig. 10, the heating device 61 is held at both sides by a holding device 62. The holding device 62 may be fixed outside the roller device by a fixation 63. The heating device and the holding device may be a heating device and a holding device as described above. Also, further rolls, roll units, guide units, or even coating drums in the deposition apparatus of Fig. 10 may be equipped with a heating device according to embodiments described herein.

In some embodiments, operational parameters may be influenced for obtaining an optimization of the heating effect. For instance, the velocity of the substrate may be influenced so as to achieve a longer or shorter contact of the substrate with the roller device, depending on the desired temperature of the substrate. According to some embodiments, the wrapping angle or the contact length of the substrate about the roller device may be varied in order to influence the heating effect. In particular, the wrapping angle of the substrate about the roller device shown in the schematic figures should be understood as being a mere example for the wrapping angle. In some embodiments, the heat transfer coefficient, the roller temperature, and the substrate thickness may also have an influence on the heating effect.,

Additionally to the heating device as described herein, a radiation heater may be used for holding the temperature of the substrate after the substrate leaves the roller device. According to some embodiments, the heating device as described herein may be used to heat up the substrate to a certain temperature, whilst a holding radiation heater may be provided for holding the substrate temperature after the substrate has left the roller device. Such a holding heating device may, for instance, be a radiation heater, e.g. an infrared heating device.

After uncoiling from the web storage spool 610 and running over the roller 604 and the web guide unit 60, the web 640 is then moved through the deposition areas 630 provided at the coating drum 611 and corresponding to positions of the deposition sources 680. During operation, the coating drum 611 rotates around the axis such that the web moves in the direction of arrow 608.

After processing, the web may run over one or more further web guide units 60 (in the embodiment of FIG. 10, it runs over one web guide unit). In addition, it may run over further rolls, such as rollers 604 depicted in FIG. 10. As the web coating in the embodiment of FIG. 10 is accomplished at that position, the web is wound up on a spool 664. According to some embodiments, also the roller devices being located after the deposition areas 630 may be equipped with a heating device in the roller device as described in embodiments above.

The web 640 may be coated with one or more thin films, i.e. one or more layers are deposited on the web 640 by deposition sources 680. The deposition takes place while the substrate is guided on the coating drum 611. A gas flow of processing gas can be provided from the outer portions of that deposition source 680 to the inner portion of that deposition source.

Embodiments described herein may refer inter alia to a plasma deposition system for depositing, from a plasma phase, thin films onto a moving substrate. The web may move in a substrate transport direction in a vacuum chamber where a plasma deposition source for transferring a deposition gas into a plasma phase and for depositing, from the plasma phase, a thin film onto the moving substrate is located.

As shown in FIG. 10, and in accordance with embodiments described herein, a plasma deposition source 680 can be provided as a PECVD (plasma-enhanced chemical vapor deposition) source having a multi-region electrode device including two, three or even more RF (radio frequency) electrodes arranged opposite to a moving web. According to embodiments, multi region plasma deposition sources can also be provided for MF (middle frequency) deposition.

According to embodiments, the deposition apparatus may include more than one coating unit, such as more than one coating drum 611. It is possible to provide a roller device as described herein before each of the two or more coating drums. Additionally or alternatively, each coating unit, such as a coating drum, may be provided with one, two, three, or even more deposition sources.

According to some embodiments, a method for heating a substrate in a vacuum deposition arrangement is described. The vacuum deposition arrangement may be a deposition arrangement as described above with respect to Figs. 1 or 9 having components as exemplarily described in Figs. 2 to 9. Especially, the roller device used for performing the herein described method may be a roller device as described above. Fig. 11 shows a flow chart 700 of a method according to embodiments described herein. The method includes in box 710 guiding a substrate in a vacuum chamber using a roller device. As described above, the substrate is a flexible substrate such as e.g. a web, a foil, a thin material volume or the like. In one embodiment, the substrate may include plastic material, PET, PE, PU, metal, paper or the like.

In box 720 of the flow chart 700, an electrical heating device is held at two ends of the heating device. According to some embodiments, the heating device may be held by holding devices as exemplarily shown in Fig. 2. For instance, the holding devices may be able to fix the heating device in the vacuum chamber, or in the deposition arrangement. The method according to embodiments described herein may include fixing the heating device. In one embodiment, holding the heating element may include providing the roller device on the holding devices in a rotatable manner.

In box 730, the roller device is heated by the electrical heating device. The electrical heating device may be designed as described before and may especially include the features of the heating devices shown in Figs. 2 to 9. The electrical heating device used in the method of heating a substrate may be a heating device, especially a radiation heating device, which is able to heat the surrounding roller device contactless. In one embodiment, the heating device may be an infrared heating device. According to some embodiments, the substrate is heated by contacting the heated surface of the roller device.

In one embodiment, the side of the heating device facing the roller device and the roller device are held substantially at the same electrical potential, e.g. ground potential. As explained above, the electrical heating device may be designed so as to avoid a voltage difference between the roller device and the surface of the heating device. In one embodiment, the method of heating a substrate includes isolating at least a part of the heating device for avoiding a voltage difference between the heating device surface and the roller device.

In addition to the heating device as described herein, an external radiation heater may be used for holding the temperature of the substrate after the substrate leaves the roller device. For holding a temperature of about 70°C of the substrate, a power density of about 500 W/m of the external heater may be used.

Embodiments described herein may be used for all kinds of thermal treatment of (plastic) films, foils, or webs. The treatment may be used in a vacuum as well as in the atmosphere before coating, or, if applicable, after coating (e.g. for annealing purposes). The skilled person will understand how the rollers are to be adapted for such applications of the herein described embodiments without any inventive skills.

While the foregoing is directed to embodiments of the invention, other and further embodiments of the invention may be devised without departing from the basic scope thereof, and the scope thereof is determined by the claims that follow.

## Claims

1. A deposition arrangement (100; 600) for depositing a material on a flexible substrate (110; 640), comprising:
a vacuum chamber (120);
a roller device (200; 300; 400; 500; 604) provided within the vacuum chamber (120); and
an electrical heating device (61; 220; 320; 420; 520) within the roller device (200; 300; 400; 500; 604),
wherein the electrical heating device (61; 220; 320; 420; 520) comprises a first end (250) and a second end (260),
wherein the electrical heating device (61; 220; 320; 420; 520) is held at the first end (250) and at the second end (260),
wherein the roller device (200; 300; 400; 500; 604) is passively driven, and wherein the roller device (200; 300; 400; 500; 604) is configured to be driven by a motion of the flexible substrate (110; 640) only, wherein the roller device is rotatable with respect to the electrical heating device.

2. The deposition arrangement (100; 600) according to claim 1, wherein the electrical heating device (61; 220; 320; 420; 520) is adapted to have substantially atmospheric pressure within at least a portion of the electrical heating device (61; 220; 320; 420; 520) during vacuum deposition in the deposition arrangement (100; 600).

3. The deposition arrangement (100; 600) according to any of claims 1 to 2, wherein the electrical heating device (61; 220; 320; 420; 520) is held in the vacuum chamber (120).

4. The deposition arrangement (100; 600) according to any of claims 1 to 3, wherein the roller device (200; 300; 400; 500; 604) is rotatable independently from the electrical heating device (61; 220; 320; 420; 520).

5. The deposition arrangement (100; 600) according to any of claims 1 to 4, wherein the electrical heating device (61; 220; 320; 420; 520) is held by a holding device (271; 272) at each of the first end (250) and the second end (260), and wherein the roller device (200; 300; 400; 500; 604) is rotatable provided on the holding device (271; 272) or wherein the electrical heating device (61; 220; 320; 420; 520) and the roller device (200; 300; 400; 500; 604) are supported in a vacuum chamber (120) independently from each other.

6. The deposition arrangement (100; 600) according to any of claims 1 to 5, wherein the deposition arrangement (100; 600) further comprises a vacuum generating arrangement for providing the same vacuum condition in the vacuum chamber (120) outside the roller device (200; 300; 400; 500; 604) and within the roller device (200; 300; 400; 500; 604).

7. The deposition arrangement (100; 600) according to any of claims 1 to 6, wherein the heating device (61; 220; 320; 420; 520) is adapted to provide the outer surface of the electrical heating device (61; 220; 320; 420; 520) substantially at the same electrical potential as the roller device (200; 300; 400; 500; 604) during vacuum deposition, in particular wherein the electrical potential of the outer surface of the heating device (61; 220; 320; 420; 520) deviates from the electrical potential of the roller device (200; 300; 400; 500; 604) by less than 15% of the electrical potential of the roller device (200; 300; 400; 500; 604).

8. The deposition arrangement (100; 600) according to any of claims 1 to 7, wherein the electrical potential of the roller device (200; 300; 400; 500; 604) and the electrical heating device (61; 220; 320; 420; 520) is the ground potential.

9. The deposition arrangement (100; 600) according to any of claims 1 to 8, wherein the electrical heating device (61; 220; 320; 420; 520) comprises a heating element (440), in particular a heating tube, and a heating wire (460) arranged within the heating element (440).

10. The deposition arrangement (100; 600) according to claim 9, wherein the heating wire (450) is electrically isolated with respect to the heating element (440).

11. The deposition arrangement (100; 600) according to any of claims 1 to 10, wherein the electrical heating device (61; 220; 320; 420; 520) is at least one of an infrared heating device and an inductive heating device.

12. The deposition arrangement (100; 600) according to any of claims 1 to 11, wherein the deposition arrangement (100; 600) is adapted for a flexible substrate, in particular a web.

13. The deposition arrangement (100; 600) according to any of claims 1 to 12, wherein the roller device (200; 300; 400; 500; 604) is adapted to be in contact with the flexible substrate (110; 640) in the vacuum chamber (120), in particular wherein the roller device (200; 300; 400; 500; 604) is one of a guiding roller device, a spreader roller device, a deflecting roller device, a coating roller, or an adjusting roller device.

14. A method for heating a flexible substrate (110; 640) in a vacuum deposition arrangement (100; 600), comprising
guiding (710) the flexible substrate (110; 640) in a vacuum chamber (120) using a roller device (200; 300; 400; 500; 604) provided in the vacuum chamber (120);
holding (720) an electrical heating device (61; 220; 320; 420; 520) in the roller device (200; 300; 400; 500; 604) at two ends (250; 260) of the electrical heating device (61; 220; 320; 420; 520); and
electrically heating the roller device (200; 300; 400; 500; 604) by the heating device (61; 220; 320; 420; 520) in the roller device (200; 300; 400; 500; 604), while the roller device is rotating with respect to the electrical heating device,
wherein the roller device (200; 300; 400; 500; 604) is passively driven, and
wherein the roller device (200; 300; 400; 500; 604) is driven by a motion of the flexible substrate (110; 640) only.

15. The method for heating according to claim 14, wherein the electrical heating of the flexible substrate (110; 640) includes at least one of:
heating the flexible substrate (110; 640) using the electrical heating device (61; 220; 320; 420; 520) comprising a heating element (440), in particular a heating tube, and a heating wire (460);
wherein holding (720) the electrical heating device (61; 220; 320; 420; 520) comprises fixing the two ends (250; 260) of the heating device in the vacuum chamber, in particular by holding devices (271; 272), wherein in particular the roller device (200; 300; 400; 500; 604) is rotatable provided on the holding devices (271; 272);
wherein electrically heating the roller device (200; 300; 400; 500; 604) comprises holding the outer surface of the heating device (61; 220; 320; 420; 520) at an electrical potential deviating from the electrical potential of the roller device (200; 300; 400; 500; 604) by less than 15% of the electrical potential of the roller device (200; 300; 400; 500; 604);
heating the flexible substrate (110; 640) via heating the roller device (200; 300; 400; 500; 604) by infrared radiation; and
heating the flexible substrate (110; 640) via heating the roller device (200; 300; 400; 500; 604) by induction.

## Patentansprüche

1. Abscheidungsanordnung (100; 600) zum Abscheiden eines Materials auf einem flexiblen Substrat (110; 640), umfassend:
eine Vakuumkammer (120);
eine Walzenvorrichtung (200; 300; 400; 500; 604), die innerhalb der Vakuumkammer (120) bereitgestellt ist; und
eine elektrische Heizvorrichtung (61; 220; 320; 420; 520) innerhalb der Walzenvorrichtung (200; 300; 400; 500; 604),
wobei die elektrische Heizvorrichtung (61; 220; 320; 420; 520) ein erstes Ende (250) und ein zweites Ende (260) umfasst,
wobei die elektrische Heizvorrichtung (61; 220; 320; 420; 520) am ersten Ende (250) und am zweiten Ende (260) gehalten wird,
wobei die Walzenvorrichtung (200; 300; 400; 500; 604) passiv angetrieben wird, und wobei die Walzenvorrichtung (200; 300; 400; 500; 604) konfiguriert ist, um nur durch eine Bewegung des flexiblen Substrats (110; 640) angetrieben zu werden, wobei die Walzenvorrichtung in Bezug auf die elektrische Heizvorrichtung drehbar ist.

2. Abscheidungsanordnung (100; 600) nach Anspruch 1, wobei die elektrische Heizvorrichtung (61; 220; 320; 420; 520) dazu ausgelegt ist, während der Vakuumabscheidung in der Abscheidungsanordnung (100; 600) im Wesentlichen Atmosphärendruck innerhalb mindestens eines Abschnitts der elektrischen Heizvorrichtung (61; 220; 320; 420; 520) aufzuweisen.

3. Abscheidungsanordnung (100; 600) nach einem der Ansprüche 1 bis 2, wobei die elektrische Heizvorrichtung (61; 220; 320; 420; 520) in der Vakuumkammer (120) gehalten wird.

4. Abscheidungsanordnung (100; 600) nach einem der Ansprüche 1 bis 3, wobei die Walzenvorrichtung (200; 300; 400; 500; 604) unabhängig von der elektrischen Heizvorrichtung (61; 220; 320; 420; 520) drehbar ist.

5. Abscheidungsanordnung (100; 600) nach einem der Ansprüche 1 bis 4, wobei die elektrische Heizvorrichtung (61; 220; 320; 420; 520) von einer Haltevorrichtung (271; 272) an jedem des ersten Endes (250) und des zweiten Endes (260) gehalten wird, und wobei die Walzenvorrichtung (200; 300; 400; 500; 604) drehbar an der Haltevorrichtung (271; 272) bereitgestellt ist oder wobei die elektrische Heizvorrichtung (61; 220; 320; 420; 520) und die Walzenvorrichtung (200; 300; 400; 500; 604) in einer Vakuumkammer (120) unabhängig voneinander gestützt werden.

6. Abscheidungsanordnung (100; 600) nach einem der Ansprüche 1 bis 5, wobei die Abscheidungsanordnung (100; 600) ferner eine Vakuumerzeugungsanordnung zum Bereitstellen desselben Vakuumzustands in der Vakuumkammer (120) außerhalb der Walzenvorrichtung (200; 300; 400; 500; 604) und innerhalb der Walzenvorrichtung (200; 300; 400; 500; 604) umfasst.

7. Abscheidungsanordnung (100; 600) nach einem der Ansprüche 1 bis 6, wobei die Heizvorrichtung (61; 220; 320; 420; 520) dazu ausgelegt ist, die Außenoberfläche der elektrischen Heizvorrichtung (61; 220; 320; 420; 520) im Wesentlichen auf demselben elektrischen Potenzial wie die Walzenvorrichtung (200; 300; 400; 500; 604) während der Vakuumabscheidung bereitzustellen, wobei insbesondere das elektrische Potenzial der Außenoberfläche der Heizvorrichtung (61; 220; 320; 420; 520) von dem elektrischen Potenzial der Walzenvorrichtung (200; 300; 400; 500; 604) um weniger als 15 % des elektrischen Potentials der Walzenvorrichtung (200; 300; 400; 500; 604) abweicht.

8. Abscheidungsanordnung (100; 600) nach einem der Ansprüche 1 bis 7, wobei das elektrische Potenzial der Walzenvorrichtung (200; 300; 400; 500; 604) und die elektrische Heizvorrichtung (61; 220; 320; 420; 520) das Erdungspotential ist.

9. Abscheidungsanordnung (100; 600) nach einem der Ansprüche 1 bis 8, wobei die elektrische Heizvorrichtung (61; 220; 320; 420; 520) ein Heizelement (440), insbesondere ein Heizrohr, und einen Heizdraht (460) umfasst, der innerhalb des Heizelements (440) angeordnet ist.

10. Abscheidungsanordnung (100; 600) nach Anspruch 9, wobei der Heizdraht (450) in Bezug auf das Heizelement (440) elektrisch isoliert ist.

11. Abscheidungsanordnung (100; 600) nach einem der Ansprüche 1 bis 10, wobei die elektrische Heizvorrichtung (61; 220; 320; 420; 520) mindestens eines von einer Infrarotheizvorrichtung und einer induktiven Heizvorrichtung ist.

12. Abscheidungsanordnung (100; 600) nach einem der Ansprüche 1 bis 11, wobei die Abscheidungsanordnung (100; 600) für ein flexibles Substrat, insbesondere eine Bahn, angepasst ist.

13. Abscheidungsanordnung (100; 600) nach einem der Ansprüche 1 bis 12, wobei die Walzenvorrichtung (200; 300; 400; 500; 604) dazu ausgelegt ist, in Kontakt mit dem flexiblen Substrat (110; 640) in der Vakuumkammer (120) zu sein, wobei insbesondere die Walzenvorrichtung (200; 300; 400; 500; 604) eines von einer Führungswalzenvorrichtung, einer Breitstreckwalzenvorrichtung, einer Umlenkwalzenvorrichtung, einer Beschichtungswalze oder einer Einstellwalzenvorrichtung ist.

14. Verfahren zum Erwärmen eines flexiblen Substrats (110; 640) in einer Vakuumabscheidungsanordnung (100; 600), umfassend
Führen (710) des flexiblen Substrats (110; 640) in einer Vakuumkammer (120) unter Verwendung einer Walzenvorrichtung (200; 300; 400; 500; 604), die in der Vakuumkammer (120) bereitgestellt ist;
Halten (720) einer elektrischen Heizvorrichtung (61; 220; 320; 420; 520) in der Walzenvorrichtung (200; 300; 400; 500; 604) an zwei Enden (250; 260) der elektrischen Heizvorrichtung (61; 220; 320; 420; 520); und
elektrisches Erwärmen der Walzenvorrichtung (200; 300; 400; 500; 604) durch die Heizvorrichtung (61; 220; 320; 420; 520) in der Walzenvorrichtung (200; 300; 400; 500; 604), während sich die Walzenvorrichtung in Bezug auf die elektrische Heizvorrichtung dreht,
wobei die Walzenvorrichtung (200; 300; 400; 500; 604) passiv angetrieben wird, und
wobei die Walzenvorrichtung (200; 300; 400; 500; 604) nur durch eine Bewegung des flexiblen Substrats (110; 640) angetrieben wird.

15. Verfahren zum Erwärmen nach Anspruch 14, wobei die elektrische Erwärmung des flexiblen Substrats (110; 640) mindestens eines einschließt von:
Erwärmen des flexiblen Substrats (110; 640) unter Verwendung der elektrischen Heizvorrichtung (61; 220; 320; 420; 520), die ein Heizelement (440), insbesondere ein Heizrohr, und einen Heizdraht (460), umfasst;
wobei das Halten (720) der elektrischen Heizvorrichtung (61; 220; 320; 420; 520) das Befestigen der beiden Enden (250; 260) der Heizvorrichtung in der Vakuumkammer, insbesondere durch Haltevorrichtungen (271; 272), umfasst, wobei insbesondere die Walzenvorrichtung (200; 300; 400; 500; 604) drehbar an den Haltevorrichtungen (271; 272) bereitgestellt ist;
wobei das elektrische Erwärmen der Walzenvorrichtung (200; 300; 400; 500; 604) das Halten der Außenoberfläche der Heizvorrichtung (61; 220; 320; 420; 520) auf einem elektrischen Potenzial umfasst, das von dem elektrischen Potential der Walzenvorrichtung (200; 300; 400; 500; 604) um weniger als 15 % des elektrischen Potentials der Walzenvorrichtung (200; 300; 400; 500; 604) abweicht;
Erwärmen des flexiblen Substrats (110; 640) durch Erwärmen der Walzenvorrichtung (200; 300; 400; 500; 604) durch Infrarotstrahlung; und
Erwärmen des flexiblen Substrats (110; 640) durch Erwärmen der Walzenvorrichtung (200; 300; 400; 500; 604) durch Induktion.

## Revendications

1. Agencement de dépôt (100 ; 600) pour déposer un matériau sur un substrat flexible (110 ; 640), comprenant :
une chambre à vide (120) ;
un dispositif de rouleau (200 ; 300 ; 400 ; 500 ; 604) fourni au sein de la chambre à vide (120) ; et
un dispositif de chauffage électrique (61 ; 220 ; 320 ; 420 ; 520) au sein du dispositif de rouleau (200 ; 300 ; 400 ; 500 ; 604),
dans lequel le dispositif de chauffage électrique (61 ; 220 ; 320 ; 420 ; 520) comprend une première extrémité (250) et une deuxième extrémité (260),
dans lequel le dispositif de chauffage électrique (61 ; 220 ; 320 ; 420 ; 520) est maintenu au niveau de la première extrémité (250) et au niveau de la deuxième extrémité (260),
dans lequel le dispositif de rouleau (200 ; 300 ; 400 ; 500 ; 604) est entraîné passivement, et dans lequel le dispositif de rouleau (200 ; 300 ; 400 ; 500 ; 604) est configuré pour être entraîné par un mouvement du substrat flexible (110 ; 640) uniquement, dans lequel le dispositif de rouleau peut tourner par rapport au dispositif de chauffage électrique.

2. Agencement de dépôt (100 ; 600) selon la revendication 1, dans lequel le dispositif de chauffage électrique (61 ; 220 ; 320 ; 420 ; 520) est conçu pour avoir une pression sensiblement atmosphérique au sein d'au moins une partie du dispositif de chauffage électrique (61 ; 220 ; 320 ; 420 ; 520) pendant un dépôt sous vide dans l'agencement de dépôt (100 ; 600).

3. Agencement de dépôt (100 ; 600) selon l'une quelconque des revendications 1 à 2, dans lequel le dispositif de chauffage électrique (61 ; 220 ; 320 ; 420 ; 520) est maintenu dans la chambre à vide (120).

4. Agencement de dépôt (100 ; 600) selon l'une quelconque des revendications 1 à 3, dans lequel le dispositif de rouleau (200 ; 300 ; 400 ; 500 ; 604) peut tourner indépendamment du dispositif de chauffage électrique (61 ; 220 ; 320 ; 420 ; 520).

5. Agencement de dépôt (100 ; 600) selon l'une quelconque des revendications 1 à 4, dans lequel le dispositif de chauffage électrique (61 ; 220 ; 320 ; 420 ; 520) est maintenu par un dispositif de maintien (271 ; 272) au niveau de chacune de la première extrémité (250) et de la deuxième extrémité (260), et dans lequel le dispositif de rouleau (200 ; 300 ; 400 ; 500 ; 604) peut tourner fourni sur le dispositif de maintien (271 ; 272) ou dans lequel le dispositif de chauffage électrique (61 ; 220 ; 320 ; 420 ; 520) et le dispositif de rouleau (200 ; 300 ; 400 ; 500 ; 604) sont supportés dans une chambre à vide (120) indépendamment l'un de l'autre.

6. Agencement de dépôt (100 ; 600) selon l'une quelconque des revendications 1 à 5, dans lequel l'agencement de dépôt (100 ; 600) comprend en outre un agencement de génération de vide pour fournir la même condition de vide dans la chambre à vide (120) à l'extérieur du dispositif de rouleau (200 ; 300 ; 400 ; 500 ; 604) et au sein du dispositif de rouleau (200 ; 300 ; 400 ; 500 ; 604).

7. Agencement de dépôt (100 ; 600) selon l'une quelconque des revendications 1 à 6, dans lequel le dispositif de chauffage (61 ; 220 ; 320 ; 420 ; 520) est conçu pour fournir la surface externe du dispositif de chauffage électrique (61 ; 220 ; 320 ; 420 ; 520) sensiblement au même potentiel électrique que le dispositif de rouleau (200 ; 300 ; 400 ; 500 ; 604) pendant un dépôt sous vide, en particulier dans lequel le potentiel électrique de la surface externe du dispositif de chauffage (61 ; 220 ; 320 ; 420 ; 520) dévie du potentiel électrique du dispositif de rouleau (200 ; 300 ; 400 ; 500 ; 604) de moins de 15 % du potentiel électrique du dispositif de rouleau (200 ; 300 ; 400 ; 500 ; 604).

8. Agencement de dépôt (100 ; 600) selon l'une quelconque des revendications 1 à 7, dans lequel le potentiel électrique du dispositif de rouleau (200 ; 300 ; 400 ; 500 ; 604) et du dispositif de chauffage électrique (61 ; 220 ; 320 ; 420 ; 520) est le potentiel de terre.

9. Agencement de dépôt (100 ; 600) selon l'une quelconque des revendications 1 à 8, dans lequel le dispositif de chauffage électrique (61 ; 220 ; 320 ; 420 ; 520) comprend un élément chauffant (440), en particulier un tube chauffant, et un fil chauffant (460) agencé au sein de l'élément chauffant (440).

10. Agencement de dépôt (100 ; 600) selon la revendication 9, dans lequel le fil chauffant (450) est électriquement isolé par rapport à l'élément chauffant (440).

11. Agencement de dépôt (100 ; 600) selon l'une quelconque des revendications 1 à 10, dans lequel le dispositif de chauffage électrique (61 ; 220 ; 320 ; 420 ; 520) est au moins un parmi un dispositif de chauffage infrarouge et un dispositif de chauffage à induction.

12. Agencement de dépôt (100 ; 600) selon l'une quelconque des revendications 1 à 11, dans lequel l'agencement de dépôt (100 ; 600) est conçu pour un substrat flexible, en particulier une bande.

13. Agencement de dépôt (100 ; 600) selon l'une quelconque des revendications 1 à 12, dans lequel le dispositif de rouleau (200 ; 300 ; 400 ; 500 ; 604) est conçu pour être en contact avec le substrat flexible (110 ; 640) dans la chambre à vide (120), en particulier dans lequel le dispositif de rouleau (200 ; 300 ; 400 ; 500 ; 604) est un parmi un dispositif de rouleau de guidage, un dispositif de rouleau épandeur, un dispositif de rouleau de renvoi, un rouleau de revêtement, ou un dispositif de rouleau d'ajustement.

14. Procédé pour chauffer un substrat flexible (110 ; 640) dans un agencement de dépôt sous vide (100 ; 600), comprenant
le guidage (710) du substrat flexible (110 ; 640) dans une chambre à vide (120) en utilisant un dispositif de rouleau (200 ; 300 ; 400 ; 500 ; 604) fourni dans la chambre à vide (120) ;
le maintien (720) d'un dispositif de chauffage électrique (61 ; 220 ; 320 ; 420 ; 520) dans le dispositif de rouleau (200 ; 300 ; 400 ; 500 ; 604) au niveau de deux extrémités (250 ; 260) du dispositif de chauffage électrique (61 ; 220 ; 320 ; 420 ; 520) ; et
le chauffage électrique du dispositif de rouleau (200 ; 300 ; 400 ; 500 ; 604) par le dispositif de chauffage (61 ; 220 ; 320 ; 420 ; 520) dans le dispositif de rouleau (200 ; 300 ; 400 ; 500 ; 604), alors que le dispositif de rouleau tourne par rapport au dispositif de chauffage électrique,
dans lequel le dispositif de rouleau (200 ; 300 ; 400 ; 500 ; 604) est entraîné passivement, et
dans lequel le dispositif de rouleau (200 ; 300 ; 400 ; 500 ; 604) est entraîné par un mouvement du substrat flexible (110 ; 640) uniquement.

15. Procédé de chauffage selon la revendication 14, dans lequel le chauffage électrique du substrat flexible (110 ; 640) inclut au moins un parmi
le chauffage du substrat flexible (110 ; 640) en utilisant le dispositif de chauffage électrique (61 ; 220 ; 320 ; 420 ; 520) comprenant un élément chauffant (440), en particulier un tube chauffant, et un fil chauffant (460) ;
dans lequel le maintien (720) du dispositif de chauffage électrique (61 ; 220 ; 320 ; 420 ; 520) comprend la fixation des deux extrémités (250 ; 260) du dispositif de chauffage dans la chambre à vide, en particulier par des dispositifs de maintien (271 ; 272), dans lequel en particulier le dispositif de rouleau (200 ; 300 ; 400 ; 500 ; 604) peut tourner fourni sur les dispositifs de maintien (271 ; 272) ;
dans lequel le chauffage électrique du dispositif de rouleau (200 ; 300 ; 400 ; 500 ; 604) comprend le maintien de la surface externe du dispositif de chauffage (61 ; 220 ; 320 ; 420 ; 520) à un potentiel électrique déviant du potentiel électrique du dispositif de rouleau (200 ; 300 ; 400 ; 500 ; 604) de moins de 15 % du potentiel électrique du dispositif de rouleau (200 ; 300 ; 400 ; 500 ; 604) ;
le chauffage du substrat flexible (110 ; 640) par l'intermédiaire d'un chauffage du dispositif de rouleau (200 ; 300 ; 400 ; 500 ;
604) par rayonnement infrarouge ; et
le chauffage du substrat flexible (110 ; 640) par l'intermédiaire d'un chauffage du dispositif de rouleau (200 ; 300 ; 400 ; 500 ; 604) par induction.
